# EUROPÄISCHE PATENTSCHRIFT

(11) **EP 1 169 671 B1**
(45) Veröffentlichungstag und Bekanntmachung des Hinweises auf die Patenterteilung: **11.09.2002**
(21) Anmeldenummer: 00929257.4
(22) Anmeldetag: 24.03.2000
(51) Int. Cl.: G05B 19/00, B23Q 17/00

(54) **VORRICHTUNG UND VERFAHREN ZUR DETEKTION EINES WERKSTÜCKES IN EINER AUTOMATISCHEN BEARBEITUNGSVORRICHTUNG**
DEVICE AND METHOD FOR DETECTING A WORKPIECE IN AN AUTOMATIC PROCESSING DEVICE
PROCEDE ET DISPOSITIF POUR DETECTER LA PRESENCE D'UNE PIECE DANS UN DISPOSITIF D'USINAGE AUTOMATIQUE

(30) Priorität: 24.03.1999 DE 19913365
(43) Veröffentlichungstag der Anmeldung: 09.01.2002
(73) Patentinhaber: Infineon Technologies AG, 81669 München (DE)
(72) Erfinder: BRADL, Stephan, D-93096 Koefering (DE); HEITZSCH, Olaf, D-01640 Coswig (DE)
(74) Vertreter: Kindermann, Peter, Dipl.-Ing.
(86) Internationale Anmeldenummer: DE0000943
(87) Internationale Veröffentlichungsnummer: WO00057251

(56) Entgegenhaltungen:
- WO-A-98/42605
- US-A- 4 562 756
- US-A- 5 823 853
- WAVERING J. ET AL.: "The application of Ultrasonic Ranging and Group Technology Concepts to Robot Material Handling Tasks" ENGINEERING COSTS AND PRODUCTION ECONOMICS, Bd. 16, Nr. 4, 1989, Seite 291-302 XP000917556 Amsterdam, NL

## Beschreibung

In modernen Fertigungsanlagen werden zunehmend automatische Bearbeitungsvorrichtungen eingesetzt, in denen ein Werkstück ohne Eingriff eines menschlichen Operateurs bearbeitet wird. Bei Vorrichtungen, die das zu bearbeitende Werkstück von einer vorgeschalteten Einheit erhalten, muß sichergestellt werden, daß die Übergabe erfolgt ist, d.h. das Werkstück sich in einer dafür vorgesehenen Halterung auch tatsächlich befindet. Bei Bearbeitungsvorrichtungen, die selbständig aus einem Pool von Werkstücken eines herausgreifen, stellt sich dieselbe Aufgabe. Hinzu kommt, daß teilweise auch während der Bearbeitung eines Werkstückes dieses verloren gehen kann, z.B. indem es aus seiner Halterung rutscht. Auch dieser Zustand muß erkannt werden, damit die Vorrichtung die Bearbeitung unterbrechen und adäquat reagieren kann, z.B. durch Informieren des Bedienpersonals bzw. Abbruch der Bearbeitung.

Verschiedene Verfahren sind entwickelt worden, um die Anwesenheit eines Werkstücks festzustellen, wie optische Detektoren (Kameras, Lichtschranken) oder elektrische Kontakte. Ein optisches Verfahren ist beispielsweise in der US 5,823,853 beschrieben.

Anhand des Beispiels einer Waferpoliereinrichtung soll im folgenden gezeigt werden, wie solche Erkennungsmechanismen im Stand der Technik realisiert worden sind.

Waferpoliereinrichtungen dienen dem Polieren von Wafern, monokristallinen, flachen Siliziumscheiben, die für die Herstellung integrierter Schaltungen verwendet werden können.

Der Wafer wird dabei auf ein Poliertuch gelegt und mittels eines Polierwerkzeugs (Polierkopf, "Carrier") gehaltert. Auf das Poliertuch wird ein Poliermittel ("Slurry") aufgebracht und eine Relativbewegung von Poliertuch und Wafer erzeugt.

Während des Poliervorganges eines Wafers kann es in seltenen Fällen durch verschiedene Irregularitäten, wie z.B. Werkzeugprobleme, Prozeßinstabilitäten, Fehlern im Transport oder der Bereitstellung der. Wafer zu Waferverlusten auf den sog. Polierplaten kommen. Um daraus resultierende Schäden für den verlorengegangenen Wafer und das Polierwerkzeug wie auch die Unterlage zu minimieren oder im besten Fall ganz zu verhindern, ist eine schnelle Detektion eines Waferverlustes wichtig, um den Poliervorgang unterbrechen zu können.

Poliermaschinen des Standes der Technik verfügen daher teils über optische Sensoren, die anhand des unterschiedlichen optischen Reflexionsvermögens von Wafer einerseits und Unterlage (Poliertuch) andererseits einen Verlust des Wafers detektieren können. Abhängig von der Oberflächenbeschaffenheit eines Wafers bzw. der Farbe des verwendeten Poliertuches sind diese Sensoren jedoch zur zuverlässigen Detektion der Anwesenheit eines Wafers nur begrenzt geeignet, da sie Wafer und Poliertuch nicht immer unterscheiden können. Sie sind daher nicht universell einsetzbar und führen mitunter zu Fehldetektionen. Viele der üblicherweise verwendeten Poliermittel führen darüberhinaus zu einer Einfärbung des Poliertuches, was in einer Änderung des Reflexionsverhaltens resultiert. Dieser Effekt tritt vor allem bei Poliermitteln für das Metallpolieren auf. Durch diese Probleme wird der Anteil an Fehldetektionen erhöht, was einer störungsfreien und automatischen Bearbeitung der Wafer in der Poliermaschine zuwiderläuft.

Aus der Druckschrift WO-A-98/42605 ist ein Verfahren zur Erkennung eines Werkstücks bekannt, bei dem eine Oberfläche eines Stücks Stoff mit Ultraschall beschallt wird. Hierbei wird mittels des reflektierten Schalls festgestellt, ob der Stoff richtig oder falsch herum liegt.

Ein weiteres Verfahren zur Detektion der An- oder Abwesenheit eines Wafers wurde im Stand der Technik vorgeschlagen. Bei diesem wird das Vakuum am Polierkopf gemessen, um somit einen eventuellen Waferverlust durch den dabei auftretenden Vakuumeinbruch zu detektieren.

Mit dieser Art von Detektion ist es zwar möglich, den Wafertransport zu überwachen, der mit dem Polierkopf bewerkstelligt wird. Eine Detektion während des eigentlichen Poliervorgangs ist jedoch in vielen Fällen nicht möglich, da häufig zum Erreichen eines gleichmäßigen Abtrags zwischen dem Wafer und dem Polierkopf ein Gaspolster von hinten an den Wafer angelegt wird, so daß während des Polierens kein meßbares Vakuum zur Verfügung steht.

Zusammenfassend kann man sagen, daß derzeit kein Verfahren zur Detektion der Anwesenheit oder Abwesenheit eines Wafers in einer Poliermaschine zur Verfügung steht, das allen Anforderungen Genüge tut.

Neben den oben beschriebenen Waferpolieranlagen finden sich auch bei anderen Bearbeitungseinrichtungen für Werkstücke Probleme mit bestimmten vorbekannten Detektionsmethoden, die deren universelle Verwendbarkeit einschränken.

Es ist daher die Aufgabe der vorliegenden Erfindung, einen Detektor für die An- oder Abwesenheit eines Werkstücks in einer Bearbeitungsvorrichtung bereitzustellen, der einen physikalisch anders gearteten Ansatz der Unterscheidung von Werkstück und Halterung bzw. Bearbeitungsvorrichtung zur Verfügung stellt und damit eine nach anderen physikalischen Größen erfolgende Unterscheidung ermöglicht.

Erfindungsgemäß wird diese Aufgabe gelöst durch die Bereitstellung eines Detektionsverfahrens gemäß dem unabhängigen Patentanspruch 1 sowie die Detektionsvorrichtung gemäß dem unabhängien Patentanspruch 12. Weitere vorteilhafte Ausgestaltungen ergeben sich aus den abhängigen Ansprüchen, der Beschreibung und den beigefügten Zeichnungen.

In einem Aspekt macht sich die Erfindung das unterschiedliche akustische Reflexionsvermögen eines Werkstückes gegenüber seiner Umgebung, z.B. einem Greifarm oder einer Unterlage, zunutze.

In einem weiteren Aspekt dient die Erfindung insbesondere der Bereitstellung eines zuverlässig arbeitenden Waferverlustdetektionssystems.

In noch einem weiteren Aspekt soll die Erfindung die Anwendung von Schallwellen zur Detektion der Anwesenheit und Abwesenheit eines zu bearbeitenden Werkstücks beinhalten.

In einem weiteren Aspekt stellt die Erfindung Werkstückdetektionsmechanismen gerade für sehr flache Werkstücke bereit.

Demgemäß ist die Erfindung gerichtet auf ein Verfahren zur Erkennung der Anwesenheit eines Werkstücks in einer automatischen Bearbeitungsvorrichtung, das durch die folgenden Schritte gekennzeichnet ist:
1) Bereitstellung einer Halterung für ein Werkstück in einer Bearbeitungsvorrichtung;
2) Beschallung der Halterung und/oder zumindest eines Teiles der Umgebung der Halterung mit Ultraschallwellen;
3) Empfang der reflektierten Ultraschallwellen
4) Detektion anhand der reflektierten Ultraschallwellen, ob ein Werkstück in der Halterung gehaltert ist oder ob es sich außerhalb der Halterung befindet.
   Vorzugsweise erfolgt die Detektion anhand des Verhältnisses von ausgestrahlten zu empfangenen Ultraschallwellen. Üblicherweise wird eine Bearbeitung eines Werkstücks nicht aufgenommen, wenn seine Abwesenheit detektiert wird. Es kann jedoch programmtechnisch sinnvoll sein, statt dessen die Anwesenheit des Werkstückes in der Umgebung der Halterung festzustellen. Im Ergebnis entsprechen sich diese Alternativen jedoch, da Abwesenheit in der Halterung Anwesenheit in der Umgebung bedeutet.
   Das erfindungsgemäße. Verfahren kann den weiteren Schritt umfassen:
5) Bearbeiten des Werkstücks, wenn seine Anwesenheit detektiert wurde.

Die Schritte 2-4 können während der gesamten Bearbeitung des Werkstücks repetitiv durchgeführt werden. Vorzugsweise wird die Bearbeitung unterbrochen, wenn die Abwesenheit eines Werkstücks in der Halterung detektiert wird

Die Erfindung ist insbesondere auf Anwendungen gerichtet bei denen das das Werkstück flach ist, beispielsweise ein Wafer.

Die Erfindung ist ebenfalls auf eine Vorrichtung zur Erkennung der Anwesenheit eines Werkstücks in einer automatischen Bearbeitungsvorrichtung gerichtet, wobei ein Ultraschallsender zur Beschallung des Bereichs einer Werkstückhalterung in der Bearbeitungsvorrichtung, zumindest ein Ultraschallempfänger und ein Detektionsmittel zur Detektion der Anwesenheit eines Werkstückes vorgesehen sind.

Vorzugsweise umfasst der Ultraschallempfänger Mittel zur Umwandlung der Intensität der empfangenen Ultraschallwellen in ein elektrisches Signal. Das Detektionsmittel umfasst vorzugsweise Mittel zur Bestimmung der Intensität der vom Ultraschallempfänger empfangenen Ultraschallwellen, Mittel zum Vergleich der Intensität mit der Intensität der vom Ultraschallsender abgestrahlten Ultraschallwellen, und Mittel zur Entscheidung über die Anwesenheit oder Abwesenheit eines Werkstücks

Das Detektionsmittel kann Steuermittel zum Beginnen und Unterbrechen der Bearbeitung eines Werkstückes umfassen. Mehrere Ultraschallempfänger können in einer Vorrichtung vorhanden sein. Ebenso kann die Vorrichtung so eingerichtet sein, daß der Ultraschallsender gerichteten Ultraschall abgeben kann.

Im folgenden soll die Erfindung im Einzelnen beschrieben werden, wobei auf die Zeichnungen Bezug genommen wird, in denen

Fig. 1a eine Detektionsvorrichtung in einer Bearbeitungsvorrichtung mit einem Greifarm zum Haltern des Werkstücks zeigt;
Fig. 1b dieselbe Bearbeitungsvorrichtung ohne Werkstück zeigt;
Fig. 2a eine Detektionsvorrichtung in einer Waferpolieranlage mit einem Wafer zeigt; und
Fig. 2b eine Detektionsvorrichtung in einer Waferpolieranlage nach Waferverlust zeigt.

Die vorliegende Erfindung macht sich das akustische Reflexionsvermögen von Werkstücken zunutze, welches sich stets vom Reflexionsvermögen des Untergrundes, z.b. eines Poliertuchs einer Waferpolieranlage, oder vom Reflexionsvermögen eines leeren Raums, der bei Abwesenheit eines Werkstücks zwischen den Haltern eines Greifarms besteht, unterscheidet.

Von einem Ultraschallsender werden Ultraschallwellen definierter Stärke abgestrahlt, die auf das Werkstück, sofern vorhanden, und/oder auf eine Umgebung, z.B. ein Poliertuch, des Werkstücks, treffen. Von dort wird ein Teil der Ultraschallwellen reflektiert und mittels eines Ultraschallempfängers empfangen. Ein Detektionsmittel, d.h. eine Steuerung, z.B. ein Prozeßrechner, führt dann ein Detektionsverfahren durch, bei dem entschieden wird, ob ein Werkstück an der ordnungsgemäßen Stelle vorhanden ist oder nicht, wobei vom unterschiedlichenReflexionsvermögen eines Werkstückes im Vergleich zur Halterung oder einem Untergrund Gebrauch gemacht wird..

Vorzugsweise wird dazu das Verhältnis der Intensitäten der abgestrahlten zu den empfangenen Ultraschallwellen bestimmt.

Wenn kein Werkstück detektiert werden kann, wird kein Bearbeitungsschritt initiiert. Wenn die Anwesenheit eines Werkstückes detektiert werden konnte, kann die Steuerung die Bearbeitung des Werkstücks veranlassen oder anzeigen.

Falls nicht sicher angenommen werden kann, daß kein Verlust des Werkstückes während der Behandlung auftreten kann, wird vorzugsweise eine repetitive Messung durchgeführt, die eine kontinuierliche Überwachung der Werkstückanwesenheit sicherstellt.

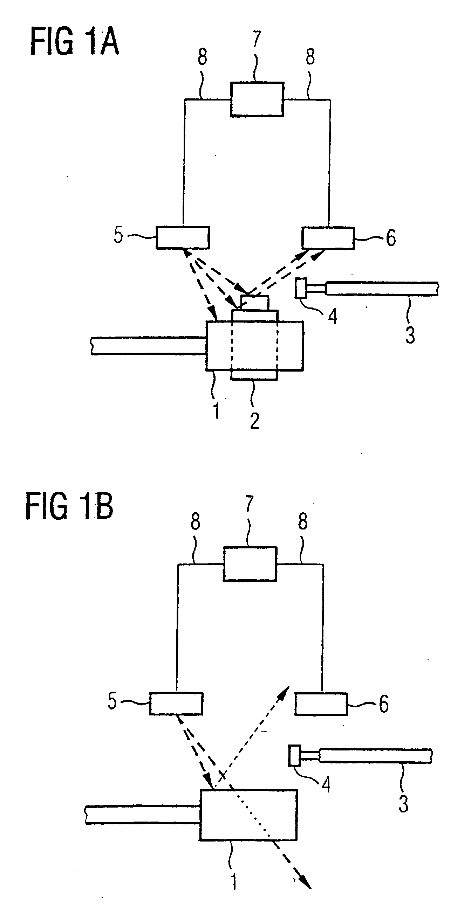

Fig. 1a zeigt schematisch eine Anordnung mit einer Werkzeugmaschine mit Greifarm 1, der ein Werkstück 2 hält. Ein Spindelantrieb 3 mit Fräskopf 4 steht zur Bearbeitung des Werkstücks 2 bereit. Ein Ultraschallsender 5 strahlt Ultraschallwellen (Pfeil) aus, die vom Werkstück reflektiert werden und zum Ultraschallempfänger 6 gelangen. Vom Empfänger 6 werden sie in elektrische Signale umgewandelt, die von einer Steuerung 7 über eine Leitung 8 empfangen und dort ausgewertet werden. Das Werkstück 2 reflektiert einen hohen Anteil der darauf eintreffenden Ultraschallwellen und zeigt damit seine Anwesenheit.

Fig. 1b zeigt die gleiche Werkzeugmaschine mit identischen Bezugszeichen, bei der kein Werkstück vom Greifarm 1 gehaltert ist. In diesem Fall wird lediglich ein kleiner Anteil des Ultraschalls vom Greifarml reflektiert, während der größere Teil durch seine Halter hindurchgeht. Dementsprechend empfängt der Ultraschallempfänger 6 nur wenig Ultraschallwellen, so daß die Abwesenheit des Werkstück detektiert wird.

Besonders günstig kann die vorliegende Erfindung bei flachen Werkstücken, wie den oben beschriebenen Wafern, verwendet werden. Bei diesen tritt die zusätzliche Schwierigkeit auf, daß bei flachen Werkstücken eine Detektion über z.B. Lichtschranken o.ä. schwierig ist.

Die Wafer werden auf Poliertüchern poliert, die sich hinsichtlich ihrer Kompressibilität (Elastizität) deutlich von einem auf ihnen liegenden Wafer unterscheiden. Die Kopressibilität der Poliertücher ist vergleichsweise hoch, was aufgrund des damit verbundenen Schallabsorptionskoeffizienten dazu führt, daß die Schallwellen mit erheblich geringerer Intensität zurückgeworfen werden als bei einem Wafer. Poliertuch und Wafer lassen sich damit deutlich und einfach unterscheiden.

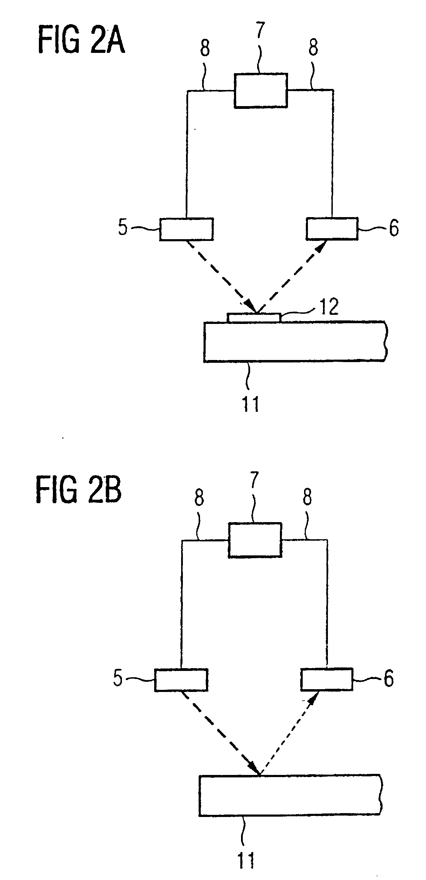

Fig. 2a zeigt schematisch eine Polieranlage für einen Wafer mit einem Poliertuch 11 als Untergrund und einem darauf angeordneten Wafer 12. Die Detektionseinrichtung selbst hat denselben Aufbau wie in Fig. 1a und b, so daß die gleichen Bezugszeichen verwendet werden. Der Wafer 12 reflektiert einen großen Anteil der auf ihn auftreffenden Ultraschallstrahlung, so daß die empfangene Intensität am Ultraschallempfänger 6 hoch ist.

In Fig. 2b ist die Polieranlage gezeigt, wenn ein Waferverlust aufgetreten ist. Das Poliertuch 11 reflektiert weniger Ultraschall als der Wafer 12, so daß entsprechend weniger Ultraschallwellen vom Ultraschallempfänger 6 empfangen werden. Anhand der Intensität des reflektierten Ultraschalls kann daher bei bekannter Abstrahlungsintensität auf einfache Weise ein Waferverlust schnell, prozeß- (z.B. Polierpaste, etc.) und hardwareunabhängig detektiert werden.

Kommerziell eingesetzte Waferhalter, sog. Carrier oder Polierkopfe, decken oftmals den Wafer von oben vollständig ab. Ein Ultrabeschallung des Wafers zur Überwachung ist daher nicht möglich. In einem solchen Fall kann es vorteilhaft sein, die Umgebung des Carriers, also beispielsweise das Poliertuch, zu beschallen. Wenn sich ein Wafer aus seiner Halterung im Carrier löst, wird er durch die Reibung zwischen ihm und dem Untergrund aus dem Carrier herausrutschen, so daß er nunmehr außerhalb des Carriers auf dem Poliertuch zu liegen kommt. In diesem Fall ändert sich das Reflexionsvermögen des Untergrundes an der Stelle, wo sich der Wafer befindet. Dieses Unterschied kann wahrgenommen und während der Auswertung als Waferverlust bewertet werden, so daß die Bearbeitungsvorrichtung angehalten werden kann.

Die Steuerung 7 dient der Detektion der An- oder Abwesenheit eines Werkstückes an der vorgesehenen Position. Es ist mit einem Mittel ausgestattet, um die vom Ultraschallempfänger erzeugten elektrischen Signale über eine Leitung 8 zu empfangen. Weiterhin verfügt es über ein Mittel, das entscheidet, ob ein Werkstück vorhanden ist oder nicht. Die Steuerung kann weiterhin über ein Mittel verfügen, daß den Ultraschallsender 5 zur Abstrahlung von Ultraschall veranlasst. Dies kann über eine weitere Leitung 8 geschehen, die Steuerung 7 und Ultraschallsender 5 miteinander verbindet. Hierdurch ist eine Sychronisierung von Abstrahlung und Messung möglich, was den Einfluß eventueller Störwellen verringert. Desweiteren kann darüber die Intensität der Abstrahlung gesteuert und somit klar definiert werden.

In einer bevorzugten Ausführungsform vergleicht die Steuerung die Intensität der abgestrahlten Ultraschallwellen mit der Intensität der vom Ultraschallempfänger empfangenen Wellen und kann aus deren Verhältnis die Detektion des Werkstückes durchführen. Die verschiedenen, zur Steuerung verwendeten Mittel lassen sich z.B. in einem Prozeßrechner unterbringen.

Vorteilhafterweise kann die Steuerung unmittelbar in die Bearbeitung des Werkstücks eingreifen, indem sie diese startet und bedarfsweise unterbricht. Dies kann über übliche Steuerleitungen zwischen Steuerung 7 und der Bearbeitungsvorichtung 3,4 erreicht werden.

Auch ist es möglich, statt eines Ultraschallempfängers 6 mehrere solcher Empfänger vorzusehen. Dies ist vorteilhaft bei komplex geformten Werkstücken oder wenn mehrere Werkstücke, z.B. mehrere Wafer, gleichzeitig bearbeitet werden sollen.

Desweiteren kann mit gerichtetem Ultraschall gearbeitet werden, um eine noch genauere Unterscheidung zwischen Anwesenheit und Abwesenheit eines Werkstücks zu erlauben. Ein gerichteter Ultraschall, der von einem speziell ausgerichteten Ultraschallsender abgestrahlt wird, ermöglicht eine genauere Anpeilung des Orts in der Vorrichtung, an dem sich das Werkstück befinden soll. Somit wird ein Einfluß von anderen Elementen in der Bearbeitungsvorrichtung minimiert, was die Präzision des Entscheidungsprozesses der Steuerung weiter verbessert.

## Patentansprüche

1. Verfahren zur Erkennung der Anwesenheit eines Werkstücks in einer automatischen Bearbeitungsvorrichtung, **gekennzeichnet durch** die folgenden Schritte:
1) Bereitstellung einer Halterung für ein Werkstück (2, 12) in einer Bearbeitungsvorrichtung;
2) Beschallung der Halterung und/oder zumindest eines Teiles der Umgebung der Halterung mit Ultraschallwellen;
3) Empfang der reflektierten Ultraschallwellen
4) Detektion anhand der reflektierten Ultraschallwellen, ob ein Werkstück in der Halterung gehaltert ist oder ob es sich außerhalb der Halterung befindet.

2. Verfahren nach Anspruch 1, **dadurch gekennzeichnet, daß** die Detektion anhand des Verhältnisses von ausgestrahlten zu empfangenen Ultraschallwellen erfolgt.

3. Verfahren nach Anspruch 1 oder 2, **dadurch gekennzeichnet, daß** eine Bearbeitung eines Werkstücks (2, 12) nicht aufgenommen wird, wenn seine Abwesenheit detektiert wird.

4. Verfahren nach einem der vorhergehenden Ansprüche, **dadurch gekennzeichnet, daß** es den weiteren Schritt umfasst:
5) Bearbeiten des Werkstücks (2, 12), wenn seine Anwesenheit detektiert wurde.

5. Verfahren nach Anspruch 4, **dadurch gekennzeichnet, daß** die Schritte 2-4 während der gesamten Bearbeitung des Werkstücks (2, 12) repetitiv durchgeführt werden.

6. Verfahren nach Anspruch 5, **dadurch gekennzeichnet, daß** die Bearbeitung unterbrochen wird, wenn die Abwesenheit eines Werkstücks (2, 12) in der Halterung detektiert wird

7. Verfahren nach einem der vorhergehenden Ansprüche, **dadurch gekennzeichnet, daß** das Werkstück (2, 12) flach ist.

8. Verfahren nach Anspruch 7, **dadurch gekennzeichnet, daß** das Werkstück ein Wafer (12) ist.

9. Verfahren nach einem der vorhergehenden Ansprüche, **dadurch gekennzeichnet, daß** die Halterung eine Auflageebene umfasst.

10. Verfahren nach einem der vorhergehenden Ansprüche, **dadurch gekennzeichnet, daß** die Halterung einen Polierkopf und ein Poliertuch (11) in einer Poliervorrichtung umfasst

11. Verfahren nach einem der Ansprüche 1-8, **dadurch gekennzeichnet, daß** die Halterung einen Greifarm (1) umfasst.

12. Vorrichtung zur Erkennung der Anwesenheit eines Werkstücks in einer automatischen Bearbeitungsvorrichtung, **gekennzeichnet durch** einen Ultraschallsender (5) zur Beschallung des Bereichs einer Werkstückhalterung (1, 11) in der Bearbeitungsvorrichtung, zumindest einen Ultraschallempfänger (6) und ein Detektionsmittel (7) zur Detektion der Anwesenheit eines Werkstückes (2, 12).

13. Vorrichtung nach Anspruch 12, **dadurch gekennzeichnet, daß** der Ultraschallempfänger (6) Mittel zur Umwandlung der Intensität der empfangenen Ultraschallwellen in ein elektrisches Signal umfasst.

14. Vorrichtung nach Anspruch 12 oder 13, **dadurch gekennzeichnet, daß** das Detektionsmittel (7) Mittel zur Bestimmung der Intensität der vom Ultraschallempfänger (6) empfangenen Ultraschallwellen, Mittel zum Vergleich der Intensität mit der Intensität der vom Ultraschallsender (5) abgestrahlten Ultraschallwellen, und Mittel zur Entscheidung über die Anwesenheit oder Abwesenheit eines Werkstücks (2, 12) umfasst

15. Vorrichtung nach einem der Ansprüche 12 bis 14, **dadurch gekennzeichnet, daß** das Detektionsmittel (7) Steuermittel zum Beginnen und Unterbrechen der Bearbeitung eines Werkstückes umfasst.

16. Vorrichtung nach einem der Ansprüche 12 bis 15, **dadurch gekennzeichnet, daß** mehrere Ultraschallempfänger vorhanden sind.

17. Vorrichtung nach einerm der vorhergehenden Ansprüche, **dadurch gekennzeichnet, daß** der Ultraschallsender (5) gerichteten Ultraschall abgeben kann.

## Claims

1. Method of detecting the presence of a workpiece in an automatic processing apparatus, **characterized by** the following steps:
1) providing a holder for a workpiece (2, 12) in a processing apparatus;
2) irradiating the holder and/or at least part of the surroundings of the holder with ultrasound waves;
3) receiving the reflected ultrasound waves;
4) using the reflected ultrasound waves to detect whether a workpiece is held in the holder or whether it is located outside the holder.

2. Method according to Claim 1, **characterized in that** the detection is carried out by using the ratio of emitted to received ultrasound waves.

3. Method according to Claim 1 or 2, **characterized in that** processing of a workpiece (2, 12) is not started if its absence is detected.

4. Method according to one of the preceding claims, **characterized in that** it comprises the further step:
5) processing the workpiece (2, 12) if its presence has been detected.

5. Method according to Claim 4, **characterized in that** steps 2-4 are carried out repetitively during the entire processing of the workpiece (2, 12).

6. Method according to Claim 5, **characterized in that** the processing is interrupted if the absence of a workpiece (2, 12) from the holder is detected.

7. Method according to one of the preceding claims, **characterized in that** the workpiece (2, 12) is flat.

8. Method according to Claim 7, **characterized in that** the workpiece is a wafer (12).

9. Method according to one of the preceding claims, **characterized in that** the holder comprises a support plane.

10. Method according to one of the preceding claims, **characterized in that** the holder comprises a polishing head and a polishing cloth (11) in a polishing apparatus.

11. Method according to one of Claims 1-8, **characterized in that** the holder comprises a gripping arm (1).

12. Apparatus for detecting the presence of a workpiece in an automatic processing apparatus, **characterized by** an ultrasound transmitter (5) for irradiating the area of a workpiece holder (1, 11) in the processing apparatus, at least one ultrasound receiver (6) and a detection means (7) for detecting the presence of a workpiece (2, 12).

13. Apparatus according to Claim 12, **characterized in that** the ultrasound receiver (6) comprises means for converting the intensity of the received ultrasound waves into an electrical signal.

14. Apparatus according to Claim 12 or 13, **characterized in that** the detection means (7) comprises means for determining the intensity of the ultrasound waves received by the ultrasound receiver (6), means for comparing the intensity with the intensity of the ultrasound waves emitted by the ultrasound transmitter (5), and means for deciding about the presence or absence of a workpiece (2, 12).

15. Apparatus according to one of Claims 12 to 14, **characterized in that** the detection means (7) comprises control means for starting and interrupting the processing of a workpiece.

16. Apparatus according to one of Claims 12 to 15, **characterized in that** there is a plurality of ultrasonic receivers.

17. Apparatus according to one of the preceding claims, **characterized in that** the ultrasonic transmitter (5) can output directed ultrasound.

## Revendications

1. Procédé pour reconnaître la présence d'une pièce à usiner dans un dispositif d'usinage automatique, **caractérisé par** les étapes suivantes :
1) réalisation d'une fixation pour une pièce à usiner (2, 12) dans un dispositif d'usinage,
2) exposition à des ondes ultrasonores, de la fixation et/ou d'au moins une partie de ce qui est à l'extérieur de la fixation,
3) réception des ondes ultrasonores réfléchies,
4) détection au moyen des ondes ultrasonores réfléchies du fait qu'une pièce à usiner est maintenue dans la fixation ou qu'elle se trouve en-dehors de la fixation.

2. Procédé selon la revendication 1 **caractérisé en ce que** la détection est obtenue à l'aide du rapport des ondes ultrasonores émises et reçues.

3. Procédé selon la revendication 1 ou 2 **caractérisé en ce qu'**un traitement d'une pièce à usiner (2, 12) n'est pas commencé si son absence est détectée.

4. Procédé selon l'une des revendications précédentes **caractérisé en ce qu'**il comprend l'étape supplémentaire :
5) traitement de la pièce à usiner (2, 12) lorsque sa présence a été détectée.

5. Procédé selon la revendication 4 **caractérisé en ce que** les étapes 2 à 4 sont réalisées de manière répétitive pendant l'ensemble du traitement de la pièce à usiner (2, 12)

6. Procédé selon la revendication 5 **caractérisé en ce que** le traitement est interrompu si l'absence d'un pièce à usiner (2, 12) est détectée dans la fixation.

7. Procédé selon l'une des revendications précédentes **caractérisé en ce que** la pièce à usiner (2, 12) est plate.

8. Procédé selon la revendication 7 **caractérisé en ce que** la pièce à usiner est une plaquette de silicium (12).

9. Procédé selon l'une des revendications précédentes **caractérisé en ce que** la fixation comprend un plan d'appui.

10. Procédé selon l'une des revendications précédentes **caractérisé en ce que** la fixation comprend une tête de polissage et une toile de polissage (11) dans un dispositif de polissage.

11. Procédé selon l'une des revendications 1 à 8 **caractérisé en ce que** la fixation comprend un bras de saisie (1).

12. Dispositif pour reconnaître la présence d'une pièce à usiner dans un dispositif d'usinage automatique **caractérisé par** un émetteur d'ultrasons (5) destiné à envoyer des ultrasons à la zone d'une fixation (1, 11) d'une pièce à usiner dans le dispositif d'usinage, au moins un récepteur d'ultrasons (6) et un moyen de détection (7) pour détecter la présence d'une pièce à usiner (2, 12).

13. Dispositif selon la revendication 12 **caractérisé en ce que** le récepteur d'ultrasons (6) comprend des moyens pour transformer l'intensité des ondes ultrasonores reçues en un signal électrique.

14. Dispositif selon la revendication 12 ou 13 **caractérisé en ce que** le moyen de détection (7) comprend des moyens pour déterminer l'intensité des ondes ultrasonores reçues par le récepteur d'ultrasons (6), des moyens pour comparer l'intensité avec l'intensité des ondes ultrasonores envoyées par l'émetteur d'ultrasons (5) et des moyens pour décider de la présence ou de l'absence d'une pièce à usiner (2, 12).

15. Dispositif selon l'une des revendications 12 à 14 **caractérisé en ce que** le moyen de détection (7) comprend des moyens de commande pour commencer et pour interrompre le traitement d'une pièce à usiner.

16. Dispositif selon l'une des revendications 12 à 15 **caractérisé en ce que** plusieurs récepteurs d'ultrasons sont présents.

17. Dispositif selon l'une des revendications précédentes **caractérisé en ce que** l'émetteur d'ultrasons (5) peut envoyer des ultrasons dirigés.
